# EUROPÄISCHE PATENTSCHRIFT

(11) **EP 0 876 631 B1**
(45) Veröffentlichungstag und Bekanntmachung des Hinweises auf die Patenterteilung: **05.03.2008**
(21) Anmeldenummer: 96934378.9
(22) Anmeldetag: 24.08.1996
(51) Int. Cl.: G02B 6/12, G02B 6/124, G02B 6/13, G03F 7/00, H01J 37/00

(54) **VERFAHREN ZUR HERSTELLUNG VON 3-DIMENSIONALEN PHOTONEN-KRISTALLEN**
SYSTEM FOR PRODUCING 3-DIMENSIONAL PHOTON CRYSTALS
PROCEDE DE PRODUCTION DE CRISTAUX PHOTONIQUES EN 3D

(30) Priorität: 08.09.1995 DE 19533148; 13.07.1996 DE 19628355
(43) Veröffentlichungstag der Anmeldung: 11.11.1998
(73) Patentinhaber: Deutsche Telekom AG, 53113 Bonn (DE)
(72) Erfinder: KOOPS, Hans, W., P., D-64372 Ober-Ramstadt (DE); LIN, Shawn-Yu, Albuquerque, NM 87185 (US)
(74) Vertreter: Kampfenkel, Klaus
(86) Internationale Anmeldenummer: PCT/DE1996/001581
(87) Internationale Veröffentlichungsnummer: WO 1997/009643

(56) Entgegenhaltungen:
- DE-A- 2 460 716
- US-A- 5 245 466
- US-A- 5 281 370
- JAPANESE JOUNAL OF APPLIED PHYSICS, Bd. 33, Nr. 12b, Dezember 1994, Seiten 7099-7107, XP000616826 H.W.P.KOOPS ET.AL.: "Characterization and application of materials grown by electron-beam-induced deposition"
- JOURNAL OF VACUUM SCIENCE&TECHNOLOGY B, Bd. 13, Nr. 3, 5.Juni 1995, Seiten 1364-1368, XP000537402 M.WEBER ET.AL.: "New compound quantum dot materials produced by electron-beam induced deposition"
- JOUNAL OF VACUUM SCIENCE&TECHNOLOGY B, Bd. 6, Nr. 1, 1.Februar 1988, Seiten 477-481, XP000616834 H.W.P.KOOPS ET.AL.: "High-resolution electron-beam induced deposition" in der Anmeldung erwähnt

## Beschreibung

Die erfindungsgemäße Lösung befaßt sich allgemein mit photonischen Kristallen und insbesondere mit photonischen Kristall-Bauelementen, welche eine Kristallstruktur mit Bandlücken ausgebildet haben.

Photonen-Kristalle mit Bandlücken sind 2- und 3- dimensionale dielektrische Strukturen, in welchen elektromagnetische Wellen abhängig oder unabhängig von ihrer Ausbreitungsrichtung verboten sind. Siehe
1. S. John, "Strong Localization of Photons in Certain Disordered Dielectric Superlattices", Phys. Rev. Lett. 58, 2486 (1987),
2. S. L. McCall, P. M. Platzman, R. Dalichaouch, D. Smith, S. Schulz, "Microwave Propagation in Two-Dimensional Dielektric Superlattices", Phys. Rev. Lett. 67, 2017 (1991),
3. K. M. Leung, Y. F. Liu, "Full Vector Wave Calculation of Photonic Band Structures in Face-Centered-Cubic Dielectric Media", Phys. Rev. Lett. 65, 2646 (1990),
4. E. Yablonovitch, T. M. Gmitter, "Photonic Band Structure: The Face-Centered-Cubic Case", Phys. Rev. Lett. 63, 1950 (1989).

Rechnungen und Mikrowellen-Messungen zeigten, daß eine kubisch flächenzentrierte oder auch eine 2-dimensional kubische Anordnung von Löchern in einer dielektrischen Matrix oder von dielektrischen Stangen solch photonische Bandlücken bewirken. Siehe
5. E. Yablonovitch, T. M. Gmitter, K. M. Leung, "Photonic Band Structure: The Face-Centered-Cubic Case Employing Nonspherical Atoms", Phys. Rev. Lett. 67, 2295 (1991) und
6. K. M. Ho, C. T. Chan, C. M. Soukoulis, "Existence of a Photonic Gap in Periodic Dielectric Structures", Phys. Rev. Lett. 65, 3152 (1990).

Dabei reichen bereits 6 Ebenen aus, um photonische Bauelemente hoher Güte zu erzielen. Siehe
7. S. Y. Lin, A. Arjavalingam "Photonic bound states in two-dimensional photonic crystals probed by coherentmicrowave transient spectroscopy". J. Opt. Soc. Am B/Vol. 11, No 10 (1994) 2124.

Derartige 2- und 3-dimensionale Strukturen, die als "Photonische Kristalle" bekannt sind, werden bei
8. S. Y. Lin, G. Arjavalingam, "Tunneling of electromagnetic waves in two-dimensional photonic crystals". Optics Letters Vol. 18, No. 19, (1993) 1666 beschrieben.

Mit dieser Technik lassen sich entsprechend theoretischen Untersuchungen eine Vielzahl von Bauelementen der integrierten Optik verbessern und neuartig miniaturisiert erzeugen. Dazu gehören beispielsweise elektromagnetische Mikro-Resonatoren für einmodige, Licht emittierende Dioden, wobei diese Strukturen, die die spontane Emission in weiten Wellenlängenbereichen unterdrücken, so die Leistungsanforderungen verringern und die Zuverlässigkeit von Lichtemittern, besonders von optischen Arrays, erhöhen. Siehe
9. E. Yablonovitch,"Inhibited Spontaneous Emission in Solid-State Physics and Electronics", Phys. Rev. Lett. 58, 2059 (1987).

Die verstärkte spontane Emission von Lichtemittern ermöglicht eine schnellere Modulationsgeschwindigkeit für optische Verbindungen und Schalter.
Optische Spiegel hoher Güte mit maßgeschneidertem Reflektions- und Transmissions-Vermögen mit geometrisch kontrollierten Wellenlängen und Durchlaß-Bandbreiten können miniaturisiert und vereinfacht aufgebaut werden, ebenso kompakte Schmalbandfilter (0,5 mm - 1 mm), Polarisatoren und Polarisation selektierende Bandpass-Filter. Gezieltes Pumpen von optoelektronischen Elementen und gerichtete Auskopplung von Licht in vorgegebene Richtung werden möglich, sowie Wellenleiter und Y-Koppler mit fast jeder Form und ultra kleinen Krümmungsradien, als auch sehr wirkungsvolle Mikrowellenantennen.
Nach dem Stand der Technik werden derartige photonische Kristalle im allgemeinen durch Bearbeitungsprozesse geschaffen, bei denen Material von einem Substrat oder ähnlichem zur Formung der Kristalle verwendet wird.
Bisher versucht man diese Strukturen durch gerichtetes chemisch unterstütztes Ionen-Strahl-Ätzen durch eine nanolithographisch hergestellte ätzresistence Maske in die Tiefe der Materie zu ätzen, um die Lochstruktur zu erzeugen. Dabei stellt die erreichbare Ebenenzahl und Tiefe der Struktur bei den geforderten Abmessungen im 100 mm Bereich höchste Anforderungen an die Lithographie und Ätztechnik. Siehe
10. C. C. Cheng, A. Scherer, "Fabrication of Photonic Bandgap crystals", J. Vac. Sci & Technol. (B) 13(6), 2696-2700 (1995).

Mit dem an sich bekannten Verfahren der additiven Lithograhie durch rechnergeführte elektronenstrahlinduzierte Deposition werden 2- und 3-dimensionale Anordnungen von langen miniaturisierten Nadeln aus dielektrischen Materialien mit Nanometer-Präzision direkt in den optischen Weg eingebaut. Siehe
11. H. W. P. Koops, R. Weiel, D. P. Kern, T. H. Baum, "High-Resolution Electron-Beam Induced Deposition", Proc. 31. Int. Symp. on Electron, Ion an Photon Beams, J. Vac. Sci. & Technol. B 6 (1) (1988) 477.

Durch die bei dem Verfahren übliche hochpräzise Rechnersteuerung des Elektronenstrahles in Ort, Zeit und Bewegungsrichtung ist es möglich, nahezu alle geforderten Geometrien der Kristalle und ihre für den gewünschten optischen Zweck gezielten Deformationen zu erzeugen.
Dadurch kann ein maßgeschneidertes optisches Verhalten der Struktur erzeugt werden. Weitere Beeinflussung der optischen Eigenschaften kann durch die Veränderung der Zusammensetzung der Ausgangsmaterialien bei dem Aufbau der Struktur erreicht werden, was zu einer geänderten Materialzusammensetzung der den Kristall aufbauenden Nadeln, geknickten Stangen oder Gitterebenen führt. Damit kann die räumliche Verteilung der Dielektrizitätskonstante im Material im Nanometerbereich gezielt eingestellt und verändert werden. Durch zusätzlich variierte Form der einzelnen dielektrischen Stäbe und durch Rechnersteuerung beim Aufbau können weitere optische Eigenschaften, wie z. B. Fokussierung, in die Anordnung integriert werden.
Als wesentliche Verbesserung gegenüber dem Stand der Technik ist die starke Verringerung der Prozeßschritte, die freie Gestaltbarkeit der Kristalle in Materialzusammensetzung, Materialanordnung und Form der einzelnen, den Kristall aufbauenden Zellen zu sehen. Die Technik ist unabhängig von den vorliegenden Materialien und kann die erforderlichen Materialien zusätzlich auf jeder Unterlage erzeugen, Raumrichtungen und Atomanordnungen können in den Gitter-Reihen frei programmiert gefertigt und verändert werden, ohne daß zusätzliche Maskenerzeugungs- und Entfernungsschritte notwendig sind. Die Technik stellt eine wesentliche Beschleunigung bei der Erprobung und Entwicklung von photonischen Kristallen dar.

Eine weitere bekannte Lösung basiert auf der Verwendung von Vielstrahl-Schreibgeräten. Mit Vielstrahl-Schreibgeräten können mit Korpuskularstrahlen diese Elemente und integrierte optische Schaltungen in wirtschaftlicher Weise mit Hilfe der additiven Lithographie gefertigt werden. Siehe
12. DE-PS 2446 789.8-33 "Korpuskularstrahloptisches Gerät zur Korpuskelbestrahlung eines Präparats",
13. DE-PS 2460 716.7 "Korpuskularstrahl optisches Gerät zur Korpuskelbestrahlung eines Präparats.
14. DE-PS 2460 715.6 "Korpuskularstrahl optisches Gerät zur Korpuskelbestrahlung eines Präparates in Form eines Flächenmusters mit mehreren untereinander gleichen Flächenelementen",
15. DE-PS 2515 550.4 "Korpuskularstrahl optisches Gerät zur Abbildung einer Maske auf ein zu bestrahlendes Präparat", und
16. M. Rüb, H. W. P. Koops, T. Tschudi "Electron beam induced deposition in a reducing image projector", Microelectronic Engineering 9 (1989) 251 - 254,

In dem Aufsatz "Characterization and Application of Materials Grown by Electron-Beam-Induced Deposition" von Hans W. P. Koops et al., Jpn. J. Appl. Phys. Vol. 33 (1994), pp. 7099-7107 ist die Elektronenstrahl-induzierte Deposition als eine Technik der additiven Lithografie beschrieben, mit der 3-dimensionale Strukturen auf einer Oberfläche adsorbiert werden können. Als Präkursor-Material werden organische oder metallorganische Substanzen verwendet. Allerdings ist dem Aufsatz kein Hinweis zu entnehmen, Photonen-Kristalle als 3-dimensionale Strukturen auf einer Substratoberflache zu adsorbieren.

Aufgabe der vorliegenden Anmeldung ist eine gegenübes den bekannten Verfahren einfachere Erzeugung eines photonischen Kristalls. Diese Aufgabe wird durch das Verfahren gemäß Anspruch 1 gelöst.

Die erfindungsgemäße Lösung hat eine kostengünstige und gegenüber den bisherigen Verfahren weniger aufwendigere Erzeugung von photonischen Bauelementen zum Ziel, welche auf ihrer Substratoberfläche eine Vielzahl von in Abständen angeordneten photonische Elementen aufweisen sollen.

Mittels des Verfahrens soll es weiterhin möglich sein, die das photonische Bauelement bestimmenden einzelnen photonischen Komponenten entsprechend der gewünschten Struktur gezielt auf der Substratoberfläche zu plazieren, sowie während des Verfahrens Einfluß auf Abmessung, Materialzusammensetzung und Brechungsindex zu nehmen.

Die erfindungsgemäße Lösung ist auf die weitere Miniaturisierung photonischer Bauelemente ausgerichtet.

Die erfindungsgemäße Lösung beinhaltet ein Verfahren zur Herstellung von 3-dimensionalen Photonen-Kristallen, welches auf den an sich bekannten Verfahren der additiven Lithographie in Verbindung mit dem Verfahren der korpuskularstrahl-induzierten Deposition beruht. Erfindungsgemäß wird auf der Oberfläche eines Trägermaterials/Substrats als Ausgangsbasis ein Quellmaterial in Form von polymerisierbaren Präkursor-Substanzen, vorzugsweise mittels eines ausreichend hohen Dampfdruckes, aufgebracht. Dieser Vorgang wird als Sorbieren bzw. als Adsorbieren oder Absorbieren bezeichnet. Die so auf der Oberfläche des Substrats aufgebrachten polymerisierbaren Präkursor-Substanzen werden an exportierten Stellen der Oberfläche des Trägersubstrats der gezielten Einwirkung von Strahlen geladener Teilchen, wie beispielsweise von Photonen- bzw. Korpuskularstrahlen, ausgesetzt. Die vorzugsweise 2-dimensionale Einwirkung der Strahlen erfolgt dabei an vorher bestimmten Stellen des Trägermaterials und mit variierender Zeit. Die Einwirkung erfolgt bis sich an den der Strahlung ausgesetzten Stellen die polymerisierbaren Präkursor-Substanzen in nichtflüchtige Substanzen umwandeln. Die so erzeugten Bereiche von nichtflüchtigen Substanzen entsprechen in ihrem Brechungsindex und Höhenprofil der optischen Wirkung von Photonen-Kristallen.

Zur Stabilisierung der erzeugten Kristallstruktur ist es vorteilhaft, nach der Polymerisierungs-Belichtung zur Stabilisierung die Zwischenräume der 2- bzw. 3-dimensionalen Struktur des erzeugten Photonen-Kristalls mit einem für das verwendete Licht durchlässigem Material zu füllen.

Für das erfindungsgemäße Verfahren können als polymerisierbare Präkursur-Substanz (Ausgangssubstanz) bzw. als Quellmaterial Monomere, Polymere oder ein Gemisch aus Monomeren, Polymeren, sowie dielektrischen- und metallorganischen Substanzen verwendet werden. Die verwendeten Ausgangssubstanzen müssen einen für das Verfahren geeigneten Dampfdruck besitzen und durch Einstrahlung eines Strahls geladener Teilchen polymerisierbar sein.
Der für das erfindungsgemäße Verfahren erforderliche Dampfdruck läßt sich in bestimmten Fällen auch durch thermische Behandlung der Ausgangssubstanz erzeugen.

Die Ausbildung der Form und die Anordnung der als Photonen-Kristall wirkenden 2- bzw. 3-dimensionalen Struktur wird während des Verfahrensablaufs mittels Rechnersteuerung, d. h. über die Programmierung der Strahl-Führung des Photonen- bzw. Korpuskularstrahles sowie über eine rechnergesteuerte Material-Zuführung bestimmt. Der Strukturaufbau erfolgt dabei vorzugsweise sequentiell. Denkbar wäre auch ein paralleler Strukturaufbau. Dabei erfolgt die Programmierung und damit die Steuerung der Strahl-Führung und der Materialzuführung vorzugsweise unter Anwendung von parallelen Strahlen mittels der an sich bekannten Vielstrahl- oder Maskenprojektionstechnik. Neben der durch die Programmierung festgelegten Kristall-Struktur und den daraus resultierenden Eigenschaften des Photonen-Kristalls können zusätzliche optische Eigenschaften, wie beispielweise eine Fokussierung, durch programmierte Modulation der Kristallzellen beim Aufbau überlagert werden.

Eine weitere vorteilhafte Ausgestaltung des erfindungsgemäßen Verfahrens beinhaltet die Anordnung von in Wellenleiter-Mustern auf dem Substrat aufgebrachten Vertiefungen. In diesen Vertiefungen werden im weiteren Verfahrensprozeß die einzelnen Kristalle der Kristallstruktur abgelagert.
Der Aufbau der einzelnen Kristalle kann dabei sowohl sequentiell als auch parallel erfolgen.
Der parallele Aufbau der Kristalle, der ebenfalls in den speziell in Wellenleiter-Mustern angebrachten Vertiefungen erfolgt, wird durch korpuskular-optische Verfahren mit vielen parallelen Strahlen, oder auch durch verkleinernde Maskenprojektion oder Kontaktkopie durchgeführt.

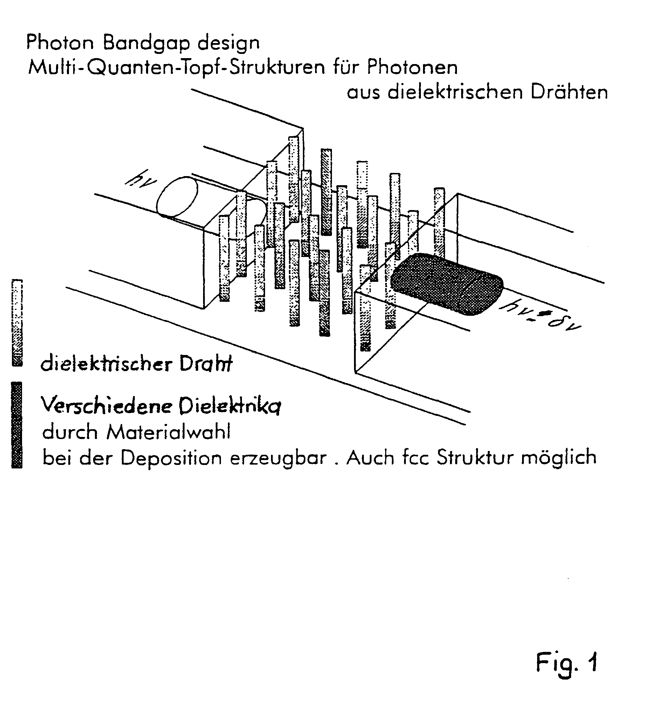

In Fig. 1 ist das Schema eines Photonen-Kristalles dargestellt, welcher als schmalbandiges Filter in einem Monomode-Wellenleiter eingesetzt ist. Die verschiedenen in unterschiedlichen Abständen angeordneten Dielektrika, die entsprechend dem erfindungsgemäßen Verfahren als Photonen-Kristalle ausgebildet sind, bilden in ihrer Gesamtheit das Filter. Die Dielektrika lassen nur elektromagnetische Wellen einer bestimmten Wellenlänge durch. Das Filter ist für alle anderen Wellenlängen, unabhängig von ihrer Ausbreitungsrichtung, undurchlässig.
Mittels der erfindungsgemäß hergestellten Photonen-Kristalle besteht die Möglichkeit, miniaturisierte integriert optische Schaltungen und Rechner-Anordnungen im Vergleich zu heutigen Bauformen mit ca. 100-facher Packungsdichte herzustellen. Derartige Bauelemente stellen einen weiteren Schritt bei der Integration der Optik in die Rechentechnik dar.

## Patentansprüche

1. Verfahren zur Herstellung eines 3-dimensionalen photonischen kristalls unter Verwendung des Verfahrens der additiven Lithographie in Verbindung mit dem Verfahren der Photonen-oder Korpuskularstrahl-induzierten Deposition zur Herstellung der 3-dimensionalen dielektrischen Struktur des photonischen Kristalls, wobei als Trägermaterial ein Substrat verwendet wird, wobei
auf einer Oberfläche des Substrats polymerisierbare Präkursor-Substanzen vorzugsweise mittels eines ausreichend hohen Dampfdruckes adsorbiert, werden, und wobei die auf die Oberfläche des Trägermaterials aufgebrachten polymerisierbaren Präkursor-Substanzen an vorbestimmten Stellen der Einstrahlung mit einem Strahl geladener Teilchen ausgesetzt werden, wobei die bestrahlten polymerisierbaren Präkursor-Substanzen in nichtflüchtige Substanzen umgewandelt werden, welche in ihrem Brechungsindex und Höhenprofil der optischen Wirkung von photonischen Kristallen entsprechen.

2. Verfahren nach Anspruch 1, bei dem der Strahl geladener Teilchen zweidimensional über die Oberfläche des Substrats geführt wird und die Einstrahlungszeit variiert.

3. Verfahren nach Anspruch 1, bei dem nach der Polymerisierungs-Belichtung zur Stabilisierung die Zwischenräume der 3-dimensionalen Struktur des erzeugten photonischen Kristalls mit einem für das verwendete Licht durchlässigen Material gefüllt werden.

4. Verfahren nach Anspruch 1, bei dem als polymerisierbare Präkursor-Substanzen Monomere verwendet werden, die einen für das Verfahren geeigneten Dampfdruck besitzen und durch Photonen- oder Korpuskularstrahlen polymerisierbar sind.

5. Verfahren nach Anspruch 1, bei dem als polymerisierbare Präkurscr-Substanzen Polymere verwendet werden, die einen für das Verfahren geeigneten Dampfdruck besitzen und durch Photonen- oder Korpuskularstrahlen polymerisierbar sind.

6. Verfahren nach Anspruch 1, bei dem als polymerisierbare Präkursor-Substanzen ein Gemisch aus Monomeren, Polymeren, dielektrischen- und metallorganischen Substanzen verwendet wird, welches einen für das Verfahren geeigneten Dampfdruck besitzt und durch Photonen- oder Korpuskularstrahlen polymerisierbar ist.

7. Verfahren nach Anspruch 1, bei dem der für das Verfahren erforderliche Dampfdruck durch thermische Behandlung der polymerisierbaren Präkursor-Substanzen erzeugt wird.

8. Verfahren nach Anspruch 1, bei dem die Form und die Anordnung der als photonischen Kristall wirkenden 2- bzw. 3-dimensionalen Struktur durch Programmierung der Strahl-Führung und der Material-Zuführung mit Rechnersteuerung des Photonen- oder Korpuskularstrahles und der Materialzufuhr bestimmt wird, wobei der Strukturaufbau sequentiell erfolgt.

9. Verfahren nach Anspruch 1, bei dem die Form und die Anordnung der als photonischen Kristall wirkenden 2- bzw. 3-dimensionalen Struktur durch Programmierung der Strahl-Führung und der Material-zuführung mit Rechnersteuerung des Photonen- oder Korpuskularstrahles und der Materialzufuhr unter Verwendung von parallelen Strahlen in einer Vielstrahl- oder Maskenprojektionstechnik bestimmt wird.

10. Verfahren nach Anspruch 1, bei dem die Kristall-Struktur und die Eigenschaften des Elementes durch Programmierung festgelegt werden und dem Element zusätzliche optische Eigenschaften, wie Fokussierung, durch programmierte Modulation der Kristallzellen beim Aufbau überlagert werden.

11. Verfahren nach Anspruch 1, bei dem der Aufbau der photonischen Kristalle an speziell in Wellenleiter-Mustern angebrachten Vertiefungen erfolgt.

12. Verfahren nach Anspruch 1 und 11, bei dem der Aufbau der photonischen Kristalle sequentiell erfolgt.

13. Verfahren nach Anspruch 1 und 11, bei dem der Aufbau der photonischen Kristalle parallel durch Korpuskularstrahl-optische-Verfahren mit vielen parallelen Strahlen in Verbindung mit verkleinernder Maskenprojektion bzw. Kontaktkopie mehrerer photonischer Kristalle erfolgt.

## Claims

1. Method for producing a three-dimensional photonic crystal using the process of additive lithography in association with the process of photon or corpuscular beam induced deposition for producing the three-dimensional dielectric structure of the photonic crystal, whereby a substrate is used as a carrier material, whereby polymerisable precursor substances are adsorbed on a surface of the substrate preferably by means of a sufficiently high vapour pressure, and whereby the polymerisable precursor substances applied to the surface of the carrier material are exposed at predefined points to radiation with a charged particle beam, whereby the irradiated polymerisable precursor substances are transformed into non-volatile substances, the refractive index and height profile of which correspond to the optical effect of photonic crystals.

2. Method according to claim 1, wherein the charged particle beam is guided two-dimensionally over the surface of the substrate and the radiation time varies.

3. Method according to claim 1, wherein after the polymerisation exposure for the purpose of stabilisation the intermediate spaces of the three-dimensional structure of the photonic crystal produced are filled with a material which is permeable to the light used.

4. Method according to claim 1, wherein monomers which have a suitable vapour pressure for the process and can be polymerised by photon or corpuscular beams are used as polymerisable precursor substances.

5. Method according to claim 1, wherein polymers which have a suitable vapour pressure for the process and can be polymerised by photons or corpuscular beams are used as polymerisable precursor substances.

6. Method according to claim 1, wherein a mixture of monomers, polymers, dielectric and metalorganic substances having a suitable vapour pressure for the process and which can be polymerised by photon or corpuscular beams is used by way of polymerisable precursor substances.

7. Method according to claim 1, wherein the vapour pressure necessary for the process is produced through thermal treatment of the polymerisable precursor substances.

8. Method according to claim 1, wherein the form and the arrangement of the two-dimensional or three-dimensional structure acting as a photonic crystal are determined by programming the beam guiding and the material supply with computer control of the photon or corpuscular beam and the material supply, whereby the structure is formed sequentially.

9. Method according to claim 1, wherein the form and the arrangement of the two-dimensional or three-dimensional structure acting as a photonic crystal are determined by programming the beam guiding and the material supply with computer control of the photon or corpuscular beam and the material supply, using parallel beams in a multi-beam or mask projection technology.

10. Method according to claim 1, wherein the crystal structure and the properties of the element are fixed by programming and additional optical properties such as focussing are transferred to the element through programmed modulation of the crystal cells during the formation of the structure.

11. Method according to claim 1, wherein the formation of the photonic crystals is realised on depressions arranged specially in waveguide patterns.

12. Method according to claims 1 and 11, wherein the photonic crystals are formed sequentially.

13. Method according to claims 1 and 11, wherein the formation of the photonic crystals is realised in parallel through corpuscular beam optical processes with many parallel beams in association with decreasing mask projection or contact copy of a plurality of photonic crystals.

## Revendications

1. Procédé de fabrication d'un cristal photonique en trois dimensions, avec utilisation du procédé de la lithographie additive en liaison avec le procédé de dépôt induit par bombardement de photons ou par bombardement corpusculaire pour la fabrication de la structure diélectrique en trois dimensions du cristal photonique, dans lequel un substrat est utilisé en tant que matière de support, des substances précurseurs polymérisables étant adsorbées sur une surface du substrat, de préférence au moyen d'une pression de vapeur suffisamment élevée, et dans lequel les substances précurseurs polymérisables appliquées sur la surface de la matière de support sont exposées au niveau d'emplacements prédéterminés à la radiation d'un rayon de particules chargées, les substances précurseurs polymérisables exposées au rayon étant converties en substances non volatiles, dont l'indice de réfraction et le profil de hauteur correspondent à l'effet optique de cristaux photoniques.

2. Procédé selon la revendication 1, dans lequel le rayon de particules chargées est guidé en deux dimensions au-dessus de la surface du substrat, et dans lequel le temps d'exposition est varié.

3. Procédé selon la revendication 1, dans lequel, après l'exposition de polymérisation, les espaces intermédiaires de la structure à trois dimensions du cristal photonique engendré sont comblés à titre de stabilisation par une matière perméable à la lumière utilisée.

4. Procédé selon la revendication 1, dans lequel des monomères sont utilisés en tant que substances précurseurs polymérisables, monomères qui possèdent une pression de vapeur appropriée pour le procédé, et qui sont polymérisables par bombardement de photons ou par bombardement corpusculaire.

5. Procédé selon la revendication 1, dans lequel des polymères sont utilisés en tant que substances précurseurs polymérisables, polymères qui possèdent une pression de vapeur appropriée pour le procédé, et qui sont polymérisables par bombardement de photons par bombardement ou corpusculaire.

6. Procédé selon la revendication 1, dans lequel un mélange de monomères, de polymères et de substances diélectriques et organométalliques est utilisé en tant que substances précurseurs polymérisables, mélange qui possède une pression de vapeur appropriée pour le procédé, et qui est polymérisable par bombardement de photons ou par bombardement corpusculaire.

7. Procédé selon la revendication 1, dans lequel la pression de vapeur nécessaire pour le procédé est générée par un traitement thermique des substances précurseurs polymérisables.

8. Procédé selon la revendication 1, dans lequel la forme et la disposition de la structure à deux ou à trois dimensions faisant office de cristal photonique sont définies par la programmation du guidage du rayon et de l'amenée de matière, avec commande par ordinateur du bombardement de photons ou du bombardement corpusculaire et de l'amenée de la matière, la synthèse de la structure étant effectuée de façon séquentielle.

9. Procédé selon la revendication 1, dans lequel la forme et la disposition de la structure à deux ou à trois dimensions faisant office de cristal photonique sont définies par la programmation du guidage du rayon et de l'amenée de matière, avec commande par ordinateur du bombardement de photons ou du bombardement corpusculaire et de l'amenée de la matière, en utilisant des rayons parallèles dans une technique à multifaisceaux ou à projection par masquage.

10. Procédé selon la revendication 1, dans lequel la structure cristalline et les propriétés de l'élément sont définies par programmation, et dans lequel des propriétés optiques supplémentaires, telles qu'une focalisation, sont superposées à l'élément lors de la synthèse par une modulation programmée des cellules cristallines.

11. Procédé selon la revendication 1, dans lequel la synthèse des cristaux photoniques est effectuée dans des renfoncements spécifiquement pratiqués dans des modèles de guides d'ondes.

12. Procédé selon les revendications 1 et 11, dans lequel la synthèse des cristaux photoniques est effectuée de façon séquentielle.

13. Procédé selon les revendications 1 et 11, dans lequel la synthèse des cristaux photoniques est effectuée en parallèle par des procédés optiques à bombardement corpusculaire avec de nombreux rayons parallèles en liaison avec une projection par masquage réductrice ou une copie par contact de plusieurs cristaux photoniques.
